# EUROPÄISCHE PATENTANMELDUNG

(11) **EP 1 155 981 A2**
(43) Veröffentlichungstag der Anmeldung: **21.11.2001**
(21) Anmeldenummer: 01109994.2
(22) Anmeldetag: 25.04.2001
(51) Int. Cl.: B65G 47/51, B65G 60/00

(54) **Vorrichtung zum Stapeln von Plattenmaterial**

(30) Priorität: 18.05.2000 DE 10024689
(71) Anmelder: Werner Thieme GmbH & Co. KG Maschinenfabrik, D-79331 Teningen (DE)
(72) Erfinder: Kölblin, Karl, 79312 Emmendingen (DE)
(74) Vertreter: Patentanwälte Ruff, Wilhelm, Beier, Dauster & Partner

(57) **Zusammenfassung**

Beschrieben wird eine Stapelvorrichtung für Platten, bei der die Platten jeweils von Auflagestäben (13) unterstützt gefördert werden, die unabhängig von einer Fördereinrichtung sind und jeweils mit ihren Enden in vertikalen Führungsnuten (14) geführt sind. Die so geführten Auflagestäbe werden von einer schrittweise arbeitenden Fördereinrichtung (15, 16) bis in eine obere Endstellung gefördert werden, wo diese Auflagestäbe (13) zusammen mit der darauf liegenden Platte zur zweiten Fördereinrichtung (7) transportiert werden, in der analog zu der Aufwärtsbewegung in der ersten Fördereinrichtung (5) nunmehr eine schrittweise Abwärtsbewegung bis zur Ausgabestelle erfolgt. Vorteil einer solchen Bauweise ist es, dass keine Relativbewegung zwischen Platten und Auflagestäben eintritt und so eine Beschädigung der Plattenunterseite vermieden wird. Auch das sonst notwendige Ausrichten der die Platten übernehmenden Stützmittel entfällt.

## Beschreibung

Die Erfindung betrifft eine Vorrichtung zum Stapeln von Plattenmaterial, insbesondere von mit Hilfe von Siebdruckmaschinen bedruckten Platten, bei der einem Zuführbereich eine erste Fördereinrichtung zugeordnet ist, mit der die Platten schrittweise in mehreren gegenüber den Zuführbereich angehobenen Stellungen übereinander stapelbar und durch eine zweite Fördereinrichtung gleicher Art auf einen in der Höhe des Zuführbereiches liegenden Ausgabebereich zur weiteren Verarbeitung schrittweise absenkbar sind, wobei beide Fördereinrichtungen mit Stützmitteln jeweils an den Unterseiten der Platten angreifen und am oberen Ende der Fördereinrichtungen eine Übergabeeinrichtung für die horizontale Verschiebung der Platten von der ersten zur zweiten Fördereinrichtung vorgesehen ist.

Es sind solche Stapeleinrichtungen bekannt, die beispielsweise als sogenannte Staustrecken bei der Bearbeitung bedruckter Platten notwendig sind, die nacheinander mehrere Arbeitsstationen, beispielsweise Siebdruckmaschinen oder Trockner durchlaufen, deren Arbeitsgeschwindigkeit untereinander verschieden ist. Dies führt bei der kontinuierlichen Zuführung von Platten dazu, dass sich die Platten an manchen Stellen stauen, ehe sie weiter verarbeitet werden können. An solchen Stellen werden die Stapeleinrichtungen eingesetzt.

Bekannt sind dabei zum einen Stapelspeicher, die nach dem Prinzip "first in last out" funktionieren. Solche Speicher werden von unten nach oben mit den Platten beladen. Die zuletzt eingespeicherte Platte liegt unten und wird für die weitere Verarbeitung zuerst wieder entnommen.

Die eingangs genannten Stapeleinrichtungen arbeiten nach dem Prinzip "first in first out" und hier sind z.B. an umlaufenden Kettensträngen, die vertikal nach oben führen, Stützwinkel angeordnet, die den im Zuführbereich horizontal eingeführten Platten jeweils seitlich links und rechts zugeordnet sind, und die Ränder der Platte untergreifen. Die Kettenstränge takten nach der Einführung einer Platte einen Schritt nach oben. Diese erste Fördereinrichtung führt die Platten daher übereinander gestapelt nach oben. In der obersten Position, also maximal am Umkehrpunkt der Kettenstränge, werden die Platten mit einem Schieber in eine zweite Stapeleinheit mit einer Fördereinrichtung gleicher Bauart geschoben oder gezogen und dann wieder von oben nach unten gefördert.

Beim Querverschieben der Platten ist es notwendig, dass sich die Auflagewinkel der beiden Kettenstränge in der ersten und zweiten Fördereinrichtung genau in gleicher Höhe befinden. Dies lässt sich in der Praxis nicht immer verwirklichen. Bei empfindlichen Platten kann es dadurch zu einer Beeinträchtigung und Beschädigung, unter Umständen auch zu einer Zerstörung führen. Da die Platten relativ zu ihren Auflagewinkeln von der ersten auf die zweite Fördereinrichtung verschoben werden, ist es nicht zu vermeiden, dass die Platten im Auflagebereich zerkratzt werden.

Der vorliegenden Erfindung liegt daher die Aufgabe zugrunde, eine Vorrichtung zum Stapeln von Plattenmaterial der eingangs genannten Art so auszubilden, dass eine schonende Weiterbeförderung der Platten von einer ersten zu einer zweiten Fördereinrichtung gewährleistet ist.

Zur Lösung dieser Aufgabe wird bei einer Vorrichtung zum Stapeln von Plattenmaterial der eingangs genannten Art vorgesehen, dass die Stützmittel als von den Fördereinrichtungen getrennte Auflagestäbe ausgebildet sind, die beidseitig in einer Führung gehalten und durch abwechselnd mit ihnen kuppelbare Antriebe schrittweise vertikal verschiebbar sind und dass die Übergabeeinrichtung aus einer die Enden der Auflagestäbe ergreifenden Transporteinrichtung besteht.

Durch diese Maßnahmen werden die Stützmittel, im vorliegenden Fall die Auflagestäbe, durch die gesamte Stapeleinrichtung zusammen mit den Platten gefördert. Eine Relativverschiebung zwischen Stützmitteln und Platten tritt daher an keiner Stelle ein und es wird auch die Schwierigkeit umgangen, dass Stützmittel von zwei getrennten Fördereinrichtungen in der Übergabeposition exakt in gleicher Höhe ausgerichtet sein müssen.

In Weiterbildung der Erfindung können die Führungen den Abmessungen der Enden der Auflagestäbe angepasste Führungsnuten sein, die beispielsweise Teil von U-förmigen Führungsleisten sind, deren offene Seite zu den Auflagestäben hin weist.

In Weiterbildung der Erfindung können die Fördereinrichtungen jeweils als kammartig ausgebildete, vertikal hin und her bewegbare Leisten vorgesehen sein, deren etwa im Abstand der Abmessungen der Enden der Auflagestäbe angeordnete Zinken wechselweise die außerhalb der Führungsleisten liegenden, aber noch über die Platten hinausstehenden Teile der Auflagestäbe umfassen.

In Weiterbildung der Erfindung können die kammartigen Leisten dabei zweiteilig ausgebildet und spiegelbildlich zueinander angeordnet, sowie in Richtung der Auflageebene der Platten hin und her verschiebbar sein, so dass die Enden der Auflagestäbe jeweils nur von einer Hälfte der Leisten aufgenommen und schrittweise transportiert werden.

In Weiterbildung der Erfindung kann die am oberen Ende der Fördereinrichtungen vorgesehene Transporteinrichtung als ein endlos umlaufendes Förderband mit im Abstand der Auflagestäbe angeordneten Greifern ausgebildet sein, welche die Enden der obersten Auflagestäbe umgreifen und Auflagestäbe mit den Platten zur zweiten Fördereinrichtung führen. Dabei kann in Weiterbildung dieses Gedankens eine horizontale Führungsbahn für die Enden der Auflagestäbe am oberen Ende der Führungsnuten vorgesehen sein, so dass die Greifer nur die horizontale Verschiebebewegung, aber nicht die vertikale Unterstützung der Auflagestäbe übernehmen müssen. Dies vereinfacht die praktische Ausgestaltung einer solchen Einrichtung. Diese horizontale Führungsbahn liegt dabei natürlich in der Bewegungsbahn der Greifer.

In Weiterbildung der Erfindung kann die erste Fördereinrichtung innerhalb eines Gehäuses von der zweiten Fördereinrichtung durch eine wärmeisolierende Wand getrennt sein, wobei den so gebildeten beiden Schächten jeweils Gebläse zugeordnet sein können, die eine Heiß- oder Kühlluftströmung quer zum Schacht bewirken. Diese Ausgestaltung ermöglicht es in relativ einfacher Weise, die Stapeleinrichtung gleichzeitig als einen Trockner auszubilden, wobei im ersten Schacht, in dem die Platten nach oben geführt werden, beispielsweise die Trocknung durch Heißluft und im zweiten, abwärtsführenden Schacht eine Rückkühlung der Platten durch Kaltluft vorgenommen werden kann.

Die Erfindung ist anhand von Ausführungsbeispielen in den Zeichnungen dargestellt und wird im folgenden erläutert. Es zeigen:
- Fig. 1: die schematische Darstellung eines Mittellängsschnittes durch eine Stapelvorrichtung nach der Erfindung,
- Fig. 2: die Ansicht der Stapelvorrichtung nach Fig. 1 in Richtung des Pfeiles II gesehen,
- Fig. 3: eine schematische Darstellung verschiedener Arbeitspositionen einer erfindungsgemäßen Vorrichtung, aus der die Handhabung von Platten, die von Auflagestäben gehalten sind, deutlich wird.
- Fig. 4: die schematische Darstellung eines Mittellängsschnittes durch eine Stapelvorrichtung ähnlich Fig. 1, jedoch mit gegeneinander abgeteilten Förderschächten zur Bildung einer Warm- und einer Kühlzone und
- Fig. 5: den Schnitt durch Fig. 3 in Richtung der Linie IV-IV.

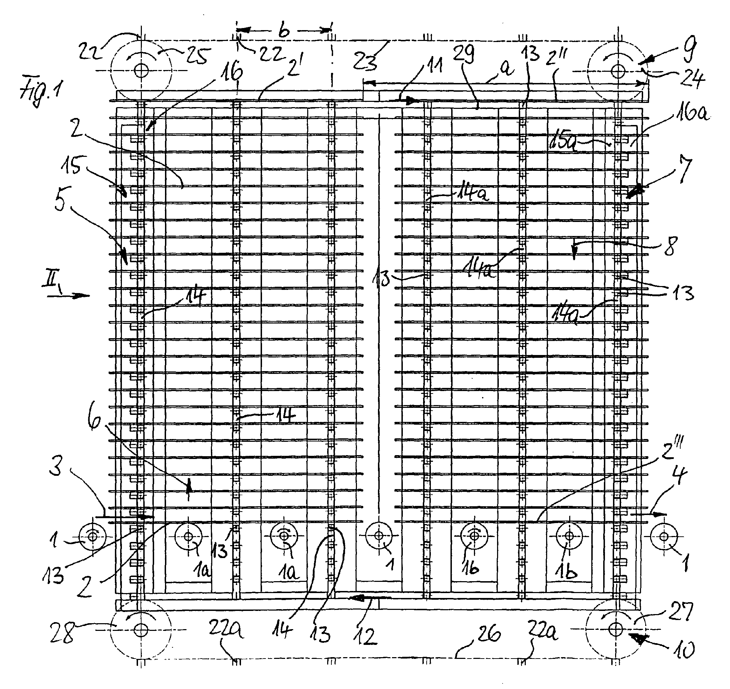

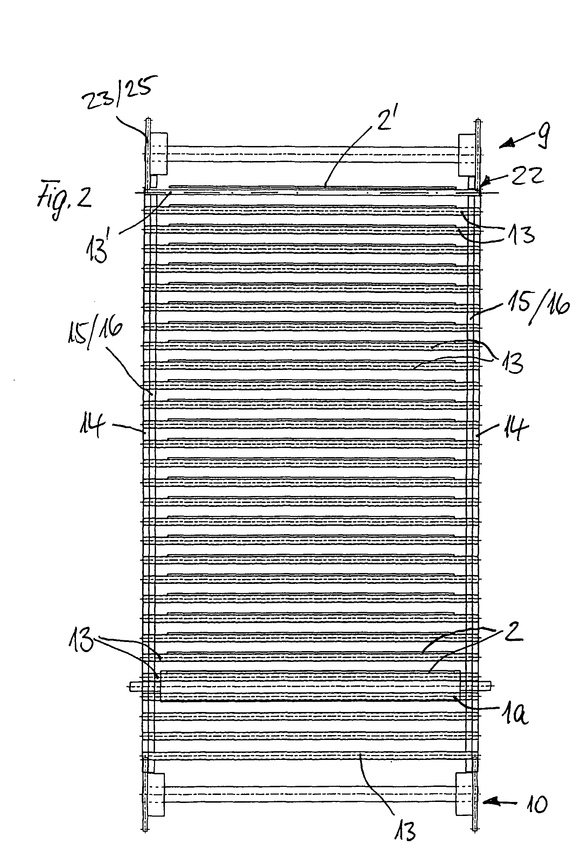

Wie Fig. 1 und 2 erkennen lassen, besteht die neue Stapelvorrichtung aus einem nicht näher dargestellten, weil bekannten Traggerüst, in dem mehrere Transportwalzen 1 in gleichem Abstand zueinander und in der gleichen Horizontalebene angeordnet sind. Diese Transportwalzen 1 besitzen alle gleiche Drehrichtung und mit ihrer Hilfe können Platten 2 im Sinne des Pfeiles 3 in einen Zuführbereich, der oberhalb der Transportwalzen 1a liegt, hereingefördert werden. Der Ausgabebereich der Stapelvorrichtung liegt oberhalb der Walzen 1b, von wo aus die Platten 2 in Richtung des Pfeiles 4 zu weiteren Bearbeitungsvorgängen weitergeleitet werden können. Wenn eine Stapelung der Platten 2 nicht erforderlich ist, dann können diese Platten über alle Transportwalzen 1, 1a und 1b in Richtung der Pfeile 3, 4 wie auf einer üblichen Fördereinrichtung weiterbewegt werden.

Für den Fall, dass eine Stapelung erforderlich wird, werden die über die Transportwalzen 1 eingeführten Platten 2 mit Hilfe einer ersten Fördereinrichtung 5 im Sinne des Pfeiles 6 schrittweise nach oben geführt und übereinander gestapelt und in einer zweiten Fördervorrichtung 7 im Sinne des Pfeiles 8 wieder nach unten bis in den Ausgabebereich gefördert. Eine am oberen Ende der beiden Fördereinrichtungen 5 und 7 angeordnete Übergabeeinrichtung 9 sorgt für einen Transport in Richtung des Pfeiles 11 und eine weitere Übergabeeinrichtung 10 für den Rücktransport der Stützeinrichtungen für die Platten 2 im Sinne des Pfeiles 12 in den Zuführbereich.

Die Platten 2 werden im Zuführbereich, also oberhalb der Transportwalzen 1a, von Auflagestäben 13 unterstützt, von denen beim Ausführungsbeispiel pro Platte drei solcher Auflagestäbe vorgesehen sind. Diese Auflagestäbe 13, welche vollständig unter den Platten durchläuft, sind dabei horizontal ausgerichtet und mit ihren beiden Enden jeweils in einer vertikalen Führung 14 gehalten, die durch Führungsnuten gebildet ist, die beispielsweise Teil von U-förmigen Führungsleisten sind, deren offene Seite zu den Auflagestäben 13 hinweist. Diese Führungsleisten sind fest im Traggerüst gehalten.

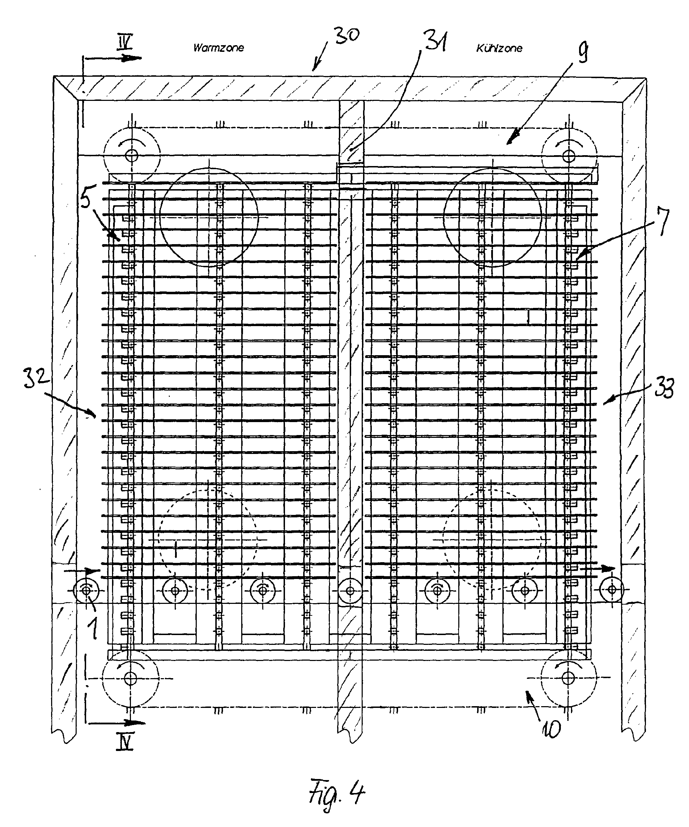

Insbesondere die Fig. 3 lässt erkennen, dass die Fördereinrichtung 5 aus kammartig ausgebildeten, vertikal bewegbaren Leisten 15 und 16 besteht, wobei der Übersichtlichkeit wegen in Fig. 3 die Leiste 15 von links unten nach rechts oben schraffiert ist, während die Leiste 16 von rechts unten nach links oben schraffiert ist. Diese Leisten sind um ein gewisses Maß sowohl horizontal verschiebbar, als auch relativ zueinander in vertikaler Richtung, so dass durch ihre Wechselbewegung eine schrittweise Anhebung der Leisten 13 mit den daraufliegenden Platten 2 bis in die oberste Endposition ermöglicht wird, was im einzelnen noch anhand der Fig. 3 erläutert wird. Wenn die als erstes eingebrachte Platte ihre oberste Stellung erreicht hat, die in Fig. 1 mit 2' bezeichnet ist, dann wird sie durch die Übergabeeinrichtung 9 um die Wegstrecke a im Sinne des Pfeiles 11 befördert in die Stellung 2'', von wo aus mit Hilfe der Fördereinrichtung 7 die schrittweise Abwärtsbewegung in der gleichen Weise bis in die unterste Stellung 2 oberhalb der Transportrollen 1b einsetzt, wie sie auch für die Aufwärtsbewegung der Platten vorgesehen ist. Die entsprechenden kammartigen Leisten der Fördereinrichtung 7 sind daher mit 15a und 16a gekennzeichnet. Natürlich sind jeder der vertikal nach oben führenden Führungsnuten 14a solche Kammleisten 15a, 16a zugeordnet, wie das auch der Fall für die Führungsnuten 14 der Fördereinrichtung 5 ist. Der Einfachheit halber ist jedoch jeweils nur die einer Vertikalreihe von Auflagestäben 13 zugeordnete Kammleistenanordnung 15, 16 bzw. 15a, 16a in Fig. 1 gezeigt.

Die Fig. 3 lässt zunächst deutlicher erkennen, dass die kammartigen Leisten 15 und 16 identisch ausgebildet, jedoch spiegelbildlich zueinander so angeordnet sind, dass jeweils die freien Enden ihrer Zinken aneinander anliegen. Die Leisten 15 und 16 sind dabei in einer ersten Grundstellung in Vertikalrichtung so zueinander versetzt, dass die oberste Ausnehmung 17 der Leiste 16 um eine Teilung der kammartigen Ausbildung versetzt über der obersten Ausnehmung 17 der Leiste 15 liegt. Diese Teilung entspricht dabei dem Stapelabstand der einzelnen Platten 2. Die Leisten 15 und 16 sind durch einen nicht näher gezeigten Antrieb zum einen jeweils um die Teilung relativ zueinander in vertikaler Richtung verschiebbar. Sie sind aber auch jeweils um die Tiefe einer Ausnehmung 17 in horizontaler Richtung verschiebbar angeordnet. Zur Erläuterung des Stapelvorganges für die Platten wird daher auf Fig. 3 Bezug genommen. Die Leisten 15 und 16 werden zunächst aus ihrer Grundstellung (links) in einem ersten Schritt horizontal nach rechts jeweils um die Tiefe einer der Ausnehmungen 17 im Sinne des Pfeiles 18 verschoben. Diese Verschiebung bewirkt daher, da die jeweiligen Ausnehmungen 17 der Leisten 15 und 16 sich nach jedem Bewegungsschritt in senkrechter Richtung wieder auf gleicher Höhe befinden, dass die Enden der Auflagestäbe 13, die sich zunächst in der Grundstellung in den Ausnehmungen 17 der Leiste 16 befunden haben, nunmehr innerhalb der Ausnehmungen 17 bzw., was den obersten Auflagestab 13' betrifft, auf der Oberkante der Leiste 15 aufliegen. In einem zweiten Schritt wird die Leiste 15 nun vertikal im Sinne des Pfeiles 19 gegenüber der Leiste 16 um eine Teilung verschoben. Der oberste Auflagestab erreicht daher die Stellung 13'' und am Ende dieser Aufwärtsbewegung die Lage 13'''. Befindet er sich in dieser Lage, wird in einem dritten Schritt wieder eine Vertikalverschiebung beider Leisten 15 und 16 im Sinn des Pfeiles 20 vorgenommen, um die weiteren Auflagestäbe schrittweise in der vorher geschilderten Art nach oben zu fördern. Im dritten Schritt, in dem der oberste Auflagestab - mit der auf ihm liegenden Platte 2 - die oberste Endlage erreicht hat, werden seine Enden von Greifern 22 erfasst, die beim Ausführungsbeispiel aus kurzen U-Profilen bestehen, die an einer umlaufenden Band- oder Ketteneinrichtung 23 befestigt sind, welche Teil der Übergabeeinrichtung 9 ist. Diese Kette 23 wird jeweils um Umlenkwalzen 24 und 25 geführt, die jeweils in nicht näher dargestellten Weise so angetrieben werden können, dass nach jedem Bewegungsschritt der Äuflagestäbe 13 nach oben auch eine Querbewegung den Betrag a im Sinn des Pfeiles 11 eintritt.

Die Greifer 22 sind dabei in solchem Abstand jeweils an der Kette 23 oder einem anderen umlenkbaren Mittel angeordnet, dass ihr Abstand b jeweils gleich groß ist und dem Abstand der Nuten 14 im Traggestell entspricht. Auf diese Weise gelangen alle Auflagestäbe, wenn sie die Stellung 13''' erreicht haben, in den Bereich innerhalb der Greifer 22, so dass alle drei Auflagestäbe mit der darauf liegenden Platte im Sinne des Pfeiles 11 (Fig. 1) in die Position verschoben werden können, in denen die auf ihnen liegende Platte die Lage 2, 2'' (Fig. 1) einnimmt. Die Auflagestäbe 13 liegen bei dieser Querverschiebung im Sinn des Pfeiles 11 auf einer Horizontalführung 29 auf, die die Führung der in den Greifern 22 aufgenommenen Enden der Auflagestäbe 13 sichert. Von hier aus beginnt die Förderung durch die Fördereinrichtung 7 nach unten analog zu der Förderung nach oben, wie sie anhand der Fördereinrichtung 5 mit Hilfe der Leisten 15 und 16 geschildert wurde. Die Fördereinrichtung 7 ist mit den Leisten 15a und 16a versehen, die ebenfalls wieder schrittweise gegeneinander in Vertikalrichtung und zusammen in Horizontalrichtung bewegbar sind. Die Auflagestäbe 13 werden durch ihre Führung in den Nuten 14a, deren Anordnung und Ausgestaltung jenen der Nuten 14 entspricht, nach unten befördert, bis die entsprechende Platte die Stellung 2''' (Fig. 1) eingenommen hat. Diese Platte kann dann im Sinn des Pfeiles 4 zur weiteren Bearbeitung nach außen aus der Stapelvorrichtung herausgefördert werden.

Die Fördereinrichtung 10 besteht ebenfalls aus einem endlosen Band oder einer Kette 26, die um Umlenkwalzen 27 bzw. 28 geführt ist. Diese Übergabeeinrichtung 10 befindet sich unterhalb der Ebene der Transportwalzen 1 und sie dient dazu, die aus der Fördereinrichtung 7 nach unten abgegebenen, nicht mehr mit einer Platte 2 versehenen Auflagestäbe im Sinn des Pfeiles 12 nach links in den Bereich unterhalb des Zuführbereiches und von dort mit Hilfe der Fördereinrichtung 5 im Sinn des Pfeiles 6 wieder nach oben zu bewegen.

Wie ohne weiteres erkennbar wird, findet innerhalb dieser Stapeleinrichtung keine Relativverschiebung zwischen Platten 2 und Auflagestäben 3 statt. Es ist zum einen für eine einwandfreie Übergabe gesorgt und ein Verkratzen durch Relativverschiebung der Platten gegenüber ihren Auflagestücken wird vermieden.

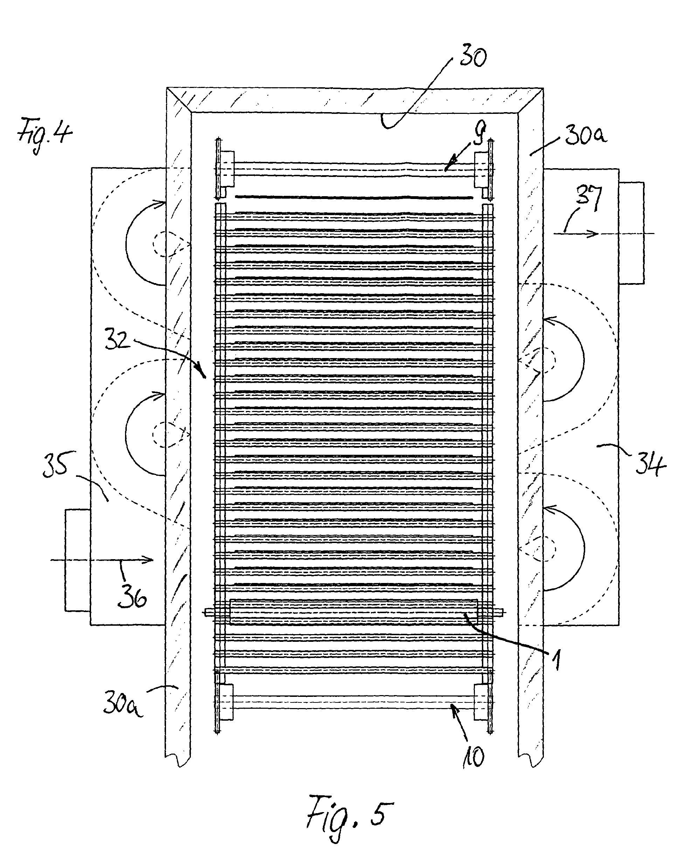

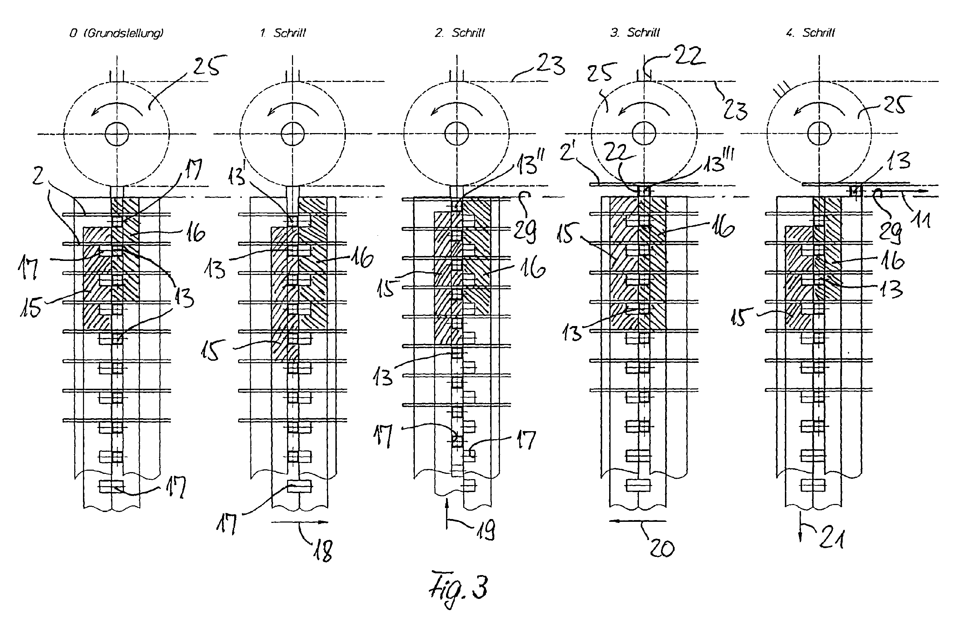

Die Fig. 4 und 5 zeigen ein weiteres Ausführungsbeispiel einer Stapeleinrichtung, die in der gleichen Weise arbeitet, wie das anhand der Fig. 1 bis 3 beschrieben wurde. Unterschiedlich ist hier, dass das Traggestell für die Stapeleinrichtung von einem wärmeisolierenden Gehäuse 30 umgeben ist, welches mit einer Trennwand 31 ausgerüstet ist, die zwischen der ersten Fördereinrichtung 5 und der zweiten Fördereinrichtung 7 liegt. Diese Trennwand 31 unterteilt daher das Gehäuse 30 in zwei parallel zueinander verlaufende Schächte 32 und 33, die jeweils für sich, z.B. mit Hilfe von an den Seitenwänden 30a des Gehäuses 30 (Fig. 5) angeordneten Gebläseeinheiten 34, 35 Warmluft oder Kaltluft im Sinn der Pfeile 36 in den Schacht 32 ein und im Sinn des Pfeiles 37 wieder aus diesem herausfördern. Auf diese Weise ist es möglich, die Stapeleinrichtung zusätzlich in eine Warmzone, die beispielsweise im Schacht 32 erzeugt wird und in eine Kühlzone, die im Schacht 33 erzeugt wird, zu unterteilen. Die Stapelvorrichtung kann auf diese Weise auch als ein Trockner eingesetzt werden. Eine im Zuge der Weiterverarbeitung der Platten vorzusehende Trocknungseinrichtung wird daher überflüssig. Natürlich wäre es auch möglich, anstelle von Warm- und Kaltluft in den hintereinanderliegenden Schächten andere Medien zu Beeinflussung der Platten und deren Oberfläche einzuleiten oder in der obersten Stellung der Platten (Lage 2') eine Bestrahlung mit UV-Licht o.dgl. zu erreichen, wenn das gewünscht ist.

## Patentansprüche

1. Vorrichtung zum Stapeln von Plattenmaterial, insbesondere von mit Hilfe von Siebdruckmaschinen bedruckten Platten, bei der einem Zuführbereich eine erste Fördereinrichtung (5) zugeordnet ist, mit der die Platten (2) schrittweise in mehreren gegenüber dem Zuführbereich angehobenen Stellungen übereinander stapelbar und durch eine zweite Fördereinrichtung (7) gleicher Art auf einen in der Höhe des Zuführbereiches liegenden Ausgabebereich zur weiteren Verarbeitung schrittweise absenkbar sind, wobei beide Fördereinrichtungen (5, 7) mit Stützmitteln (13) jeweils an den Unterseiten der Platten (2) angreifen und am oberen Ende beider Fördereinrichtungen eine Übergabeeinrichtung (9) für die horizontale Verschiebung der Platten von der ersten zur zweiten Fördereinrichtung vorgesehen ist, **dadurch gekennzeichnet, dass** die Stützmittel als von den Fördereinrichtungen (5, 7) getrennte Auflagestäbe (13) ausgebildet sind, die beidseitig in einer Führung (14, 14a) gehalten und durch abwechselnd mit ihnen kuppelbare Antriebe (15, 16) schrittweise vertikal verschiebbar sind, und dass die Übergabeeinrichtung (9) aus einer die Enden der Auflagestäbe (13) ergreifenden Transporteinrichtung besteht.

2. Vorrichtung nach Anspruch 1, **dadurch gekennzeichnet, dass** die Führungen (14, 14a) den Abmessungen der Enden der Auflagestäbe (13) angepasste Führungsnuten sind.

3. Vorrichtung nach Anspruch 2, **dadurch gekennzeichnet, dass** die Führungsnuten Teil von U-förmigen Führungsleisten sind, deren offene Seite zu den Auflagestäben (13) hin weist.

4. Vorrichtung nach Anspruch 1, **dadurch gekennzeichnet, dass** die Fördereinrichtungen (5, 7) aus kammartig ausgebildeten, vertikal hin und her bewegbaren Leisten (15, 16) bzw. (15a, 16a) bestehen, deren Zinken in einer Teilung angeordnet sind, die dem Abstand der übereinander stapelbaren Platten (2) entspricht und dass die zwischen den Zinken ausgebildeten Aussparungen (17) die außerhalb der Führungsleisten (14, 14a) liegenden, aber noch über die Platten (2) hinausstehenden Teile der Auflagestäbe (13) umfassen.

5. Vorrichtung nach Anspruch 4, **dadurch gekennzeichnet, dass** die kammartigen Leisten (15, 16) zweiteilig und identisch ausgebildet aber spiegelbildlich zueinander angeordnet sind, dass die beiden kammartigen Leisten (15, 16, 15a, 16a) in Richtung der Auflageebene der Platten (7) hin und her verschiebbar und schrittweise jeweils um eine Teilung vertikal gegeneinander verschiebbar sind, so dass die Enden der Auflagestäbe (13) jeweils nur von einer Hälfte (15) oder (16) aufgenommen und schrittweise transportiert werden.

6. Vorrichtung nach Anspruch 1, **dadurch gekennzeichnet, dass** die Transporteinrichtung aus einem endlos umlaufenden Förderband oder Kette (23) mit im Abstand (b) der Führungsnuten (14) angeordneten Greifern (22) besteht, welche die Enden der obersten Auflagestäbe (13''') umgreifen und Auflagestäbe (13) mit Platten (23) zur zweiten Fördereinrichtung (7) führen.

7. Vorrichtung nach Anspruch 6, **dadurch gekennzeichnet, dass** eine horizontale Führungsbahn (29) für die Enden der Auflagestäbe (13) am oberen Ende der Führungsnuten (14) vorgesehen ist.

8. Vorrichtung nach Anspruch 7, **dadurch gekennzeichnet, dass** die Führungsbahn (29) in der Bewegungsbahn der Greifer (22) liegt.

9. Vorrichtung nach Anspruch 1, **dadurch gekennzeichnet, dass** die erste Fördereinrichtung (5) von der zweiten Fördereinrichtung (7) durch eine wärmeisolierende Wand (31) eines Gehäuses (30) getrennt ist und dass den so gebildeten beiden Schächten (32, 33) des Gehäuses (30) jeweils Gebläse (34, 35) zugeordnet sind, die eine Heiß- oder Kühlluftströmung quer zum Schacht bewirken.
